# EUROPEAN PATENT APPLICATION

(11) **EP 2 690 146 A1**
(43) Date of publication of application: **29.01.2014**
(21) Application number: 12761389.1
(22) Date of filing: 22.03.2012
(51) Int. Cl.: C09J 7/02, H01L 21/301

(54) **ADHESIVE TAPE FOR PROCESSING SEMICONDUCTOR WAFER AND THE LIKE**

(30) Priority: 24.03.2011 JP 2011065515
(71) Applicant: Sumitomo Bakelite Co., Ltd., Shinagawa-ku Tokyo 140-0002 (JP)
(72) Inventor: ISHIBA Akihiro, Tokyo 140-0002 (JP); ISOBE Masatoshi, Tokyo 140-0002 (JP)
(74) Representative: Ahner, Philippe
(86) International application number: PCT/JP2012/057333
(87) International publication number: WO 2012/128317

(57) **Abstract**

An object of the present invention is to provide an adhesive tape for processing a semiconductor wafer or the like, which is capable of inhibiting electrical charging in a stable manner. The adhesive tape (dicing tape) (100) for processing a semiconductor wafer or the like includes a base layer (200) and an adhesive layer (300). The adhesive layer (300) is formed on the base layer (200). The adhesive layer (300) contains a curing component that cures the adhesive layer (300). The base layer (200) is composed mainly of a resin. A polymer-type antistatic agent is kneaded into the resin. The polymer-type antistatic agent has an MFR, measured under measurement conditions of 190°C and 21.18 N in accordance with JIS K7210, of at least 10.0 g/10 min and not more than 15.0 g/10 min.

## Description

### TECHNICAL FIELD

The present invention relates to an adhesive tape for processing a semiconductor wafer or the like.

Priority is claimed on Japanese Patent Application No. 2011-065515, filed March 24, 2011, the content of which is incorporated herein by reference.

### BACKGROUND ART

A variety of adhesive tapes for processing semiconductor wafers and the like used in the dicing of semiconductor wafers and packaged items (hereafter referred to as "dicing tape") have already been proposed. In a dicing tape, an adhesive layer is generally formed on a base layer, and a semiconductor wafer or the like is secured by this adhesive layer. In order to enable the semiconductor chips to be easily picked up following dicing of the semiconductor wafer or the like, a photocurable resin, a photopolymerization initiator, and a crosslinking agent and the like are typically added to the adhesive layer. In other words, following dicing, by irradiating light onto the adhesive layer, these components undergo curing, which causes a reduction in the adhesiveness of the adhesive layer and makes the semiconductor chips easier to pick up.

However, in a process for producing semiconductor chips or the like, if the dicing tape becomes electrically charged, then problems can occur such as product failure or operational problems. For example, the dicing tape can easily become charged when a separator is peeled from the dicing tape, or when the blade used during dicing makes contact with the dicing tape. Further, the dicing tape may also sometimes become charged when the dicing tape is removed from the suction table following dicing, or when the chip or package is picked up.

Accordingly, Patent Document 1 discloses a dicing tape having an adhesive layer on one surface of a base layer, and having an antistatic layer containing a friction reducing agent on the other surface. This dicing tape can inhibit electrical charging as a result of the antistatic layer.

### DOCUMENTS OF RELATED ART

### PATENT DOCUMENTS

[Patent Document 1] Japanese Unexamined Patent Application, First Publication No. 2007-99984

### SUMMARY OF THE INVENTION

### PROBLEMS TO BE SOLVED BY THE INVENTION

However, there is a possibility that the antistatic layer, which is exposed externally, may detach from the base layer as a result of contact with or scraping against machinery or the like. As a result, there is a possibility that the dicing tape described above may be unable to inhibit electrical charging in a stable manner.

An object of the present invention is to provide an adhesive tape for processing a semiconductor wafer or the like which is capable of inhibiting electrical charging in a stable manner.

### MEANS TO SOLVE THE PROBLEMS

(1) An adhesive tape for processing a semiconductor wafer or the like according to the present invention contains a base layer and an adhesive layer. The adhesive layer is formed on the base layer. Further, the adhesive layer contains a curing component that cures the adhesive layer. The base layer is composed mainly of a resin. A polymer-type antistatic agent is kneaded into and dispersed within the resin. The polymer-type antistatic agent has an MFR, measured under measurement conditions of 190°C and 21.18 N in accordance with JIS K7210, of at least 10.0 g/10 min and not more than 15.0 g/10 min.

This polymer-type antistatic agent is kneaded into the resin and dispersed through the base layer. As a result, even if the base layer makes contact with and scrapes against machinery or the like, the polymer-type antistatic agent cannot easily be separated from the base layer. Accordingly, this adhesive tape for processing a semiconductor wafer or the like can inhibit electrical charging in a stable manner. Moreover, in this polymer-type antistatic agent, the molecular chain that generates the antistatic effect is longer than that of conventional antistatic agents that are not polymer based. As a result, this adhesive tape for processing a semiconductor wafer or the like has good antistatic performance.

It became evident that an adhesive tape for processing a semiconductor wafer or the like in which the polymer-type antistatic agent has an MFR of at least 10.0 g/10 min is able to suppress any deterioration in processability. Further, an adhesive tape for processing a semiconductor wafer or the like in which the polymer-type antistatic agent has an MFR of not more than 15.0 g/10 min is able to suppress any reduction in the adhesive strength of the adhesive layer.

(2) For the adhesive tape for processing a semiconductor wafer or the like described above in (1), the 1% decay time at an applied voltage of ±5,000 V is preferably not more than 0.15 seconds.

For this adhesive tape for processing a semiconductor wafer or the like, the 1% decay time at an applied voltage of ±5,000 V is not more than 0.15 seconds. The 1% decay time describes the time taken for the voltage of the adhesive tape for processing a semiconductor wafer or the like to decay from 5,000 V to 50 V, or the time taken for the voltage to decay from -5,000 V to -50 V. This adhesive tape for processing a semiconductor wafer or the like tends to exhibit a shorter decay time than conventional adhesive tapes for processing a semiconductor wafer or the like. As a result, this adhesive tape for processing a semiconductor wafer or the like is able to better inhibit electrical charging.

(3) In the adhesive tape for processing a semiconductor wafer or the like described above in (1) or (2), the melting point of the polymer-type antistatic agent is preferably at least 140°C.

This polymer-type antistatic agent has a higher melting point than conventional polymer-type antistatic agents. By using this polymer-type antistatic agent, the melt viscosity of the base layer increases, making the extrusion processability of the base layer more favorable. Moreover, the occurrence of bleeding or contamination by low molecular weight components is inhibited.

(4) In the adhesive tape for processing a semiconductor wafer or the like described above in any one of (1) to (3), the resin is preferably a mixture of a polypropylene and an elastomer.

(5) In the adhesive tape for processing a semiconductor wafer or the like described above in any one of (1) to (3), the resin is preferably a mixture of a polyethylene and an elastomer.

(6) In the adhesive tape for processing a semiconductor wafer or the like described above in any one of (1) to (5), the polymer-type antistatic agent preferably contains not more than 100 ppm of cations and not more than 100 ppm of anions based on the weight of the polymer-type antistatic agent.

### EFFECT OF THE INVENTION

The adhesive tape for processing a semiconductor wafer or the like according to the present invention can inhibit electrical charging in a stable manner.

### BRIEF DESCRIPTION OF THE DRAWINGS

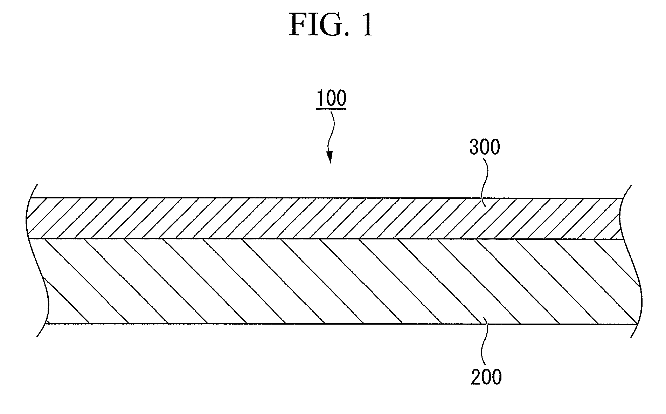

FIG. 1 is a cross-sectional view of a dicing tape according to an embodiment of the present invention.

### EMBODIMENTS OF THE INVENTION

As illustrated in FIG. 1, an adhesive tape for processing a semiconductor wafer or the like according to an embodiment of the present invention (hereafter referred to as a "dicing tape") 100 is composed mainly of a base layer 200 and an adhesive layer 300. The base layer 200 and the adhesive layer 300 are each described below in detail.

### <Base Layer>

The base layer 200 is composed mainly of a material resin into which a polymer-type antistatic agent has been kneaded. This base layer 200 performs the role of supporting the adhesive layer 300. Further, this base layer 200 has sufficient strength to withstand the expansion that occurs in the expanding step executed after the dicing step. The expanding step is a step in which the dicing tape 100 is stretched to expand the gaps between the chips. The objectives of this expanding step are to improve the recognition of the chips during pickup, and to prevent device damage caused by contact between adjacent chips.

The material resin is molded into a film using a typical film forming method. There are no particular limitations on this material resin, provided it transmits light (such as visible light, infrared rays, ultraviolet rays, X-rays and electron beams), and examples of resins that can be used include polyolefin-based resins such as polyvinyl chloride, polyethylene, polypropylene, polybutene, polybutadiene and polymethylpentene, olefin-based copolymers such as ethylene-vinyl acetate copolymers, ionomers, ethylene-(meth)acrylic acid copolymers and ethylene-(meth)acrylate ester copolymers, polyalkylene terephthalate-based resins such as polyethylene terephthalate and polybutylene terephthalate, thermoplastic resins such as styrene-based thermoplastic elastomers, olefin-based thermoplastic elastomers, polyvinyl isoprene and polycarbonate, and mixtures of these thermoplastic resins.

In terms of compatibility with the polymer-type antistatic agent, a mixture of a polypropylene and an elastomer, or a mixture of a polyethylene and an elastomer is preferably used as the material resin. A mixture of a polypropylene and an elastomer, or a mixture of a polyethylene and an elastomer imparts the dicing tape with particularly superior elongation, which has the effect of strongly suppressing breakage during the expanding step, and can therefore be used particularly favorably. Further, a dicing tape that uses a mixture of a polypropylene and an elastomer or a mixture of a polyethylene and an elastomer exhibits excellent heat resistance, is resistant to melting under conditions of 80°C or the like, and is resistant to rupture of the base layer even after storage at high temperature (60°C for approximately 3 days).

Furthermore, this elastomer is preferably a block copolymer formed from a polystyrene segment represented by general formula (1) and a vinyl polyisoprene segment represented by general formula (2). 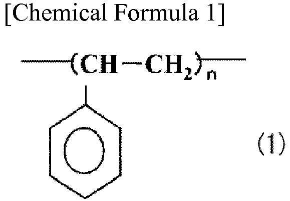 In formula (1), n represents an integer of 2 or greater. 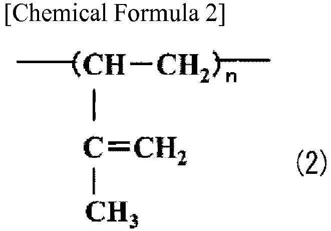 In formula (2), n represents an integer of 2 or greater.

Examples of the polymer-type antistatic agent include polyether/polyolefin block polymers containing not more than 100 ppm of cations and not more than 100 ppm of anions based on the weight of the polymer-type antistatic agent. The polymer-type antistatic agent preferably contains not more than 90 ppm of cations and not more than 90 ppm of anions, and more preferably not more than 80 ppm of cations and not more than 80 ppm of anions, based on the weight of the polymer-type antistatic agent. When the polymer-type antistatic agent contains not more than 100 ppm of cations and not more than 100 ppm of anions based on the weight of the polymer-type antistatic agent, the adhesive layer 300 is unlikely to be contaminated by ions from the polymer-type antistatic agent. Further, by ensuring that the cation content is not more than 100 ppm and the anion content is not more than 100 ppm, semiconductor circuit defects can be reduced, and the adhesive strength under high-temperature storage during transport and the like can be stabilized. Examples of this polymer-type antistatic agent include low ion elution-type agents which exhibit less ion elution than conventional polymer-type antistatic agents, and ion free-type agents which undergo substantially no ion elution. Examples of the cations contained in the polymer-type antistatic agent include sodium ions and potassium ions, and examples of the anions include sulfate ions and the like.

The melt mass flow rate (hereafter abbreviated as MFR) of the polymer-type antistatic agent, when measured under measurement conditions of 190°C and 21.18 N in accordance with JIS K7210, is preferably at least 10.0 g/10 min and not more than 15.0 g/10 min, and is more preferably at least 12.0 g/10 min and not more than 14.0 g/10 min. When the MFR of the polymer-type antistatic agent is at least 10.0 g/10 min and not more than 15.0 g/10 min, any reduction in the processability of the dicing tape 100 can be suppressed, and deterioration in the adhesive strength of the adhesive layer 300 can also be suppressed. The melting point of the polymer-type antistatic agent is preferably at least 140°C, more preferably at least 150°C, and still more preferably at least 160°C. When the melting point of the polymer-type antistatic agent is at least 140°C, the extrusion processability of the base layer 200 is more favorable.

Although there are no particular limitations on the thickness of the base layer 200, the thickness is preferably at least 50 µm and not more than 300 µm, and is more preferably at least 80 µm and not more than 200 µm. When the thickness of the base layer 200 is at least 50 µm and not more than 300 µm, the dicing tape 100 exhibits excellent workability during the dicing step and the expanding step.

There are no particular limitations on the method used for producing the base layer 200, and a typical molding method such as a calender method or extrusion molding method can be used. Functional groups that react with the material of the adhesive layer 300, such as hydroxyl groups or amino groups, are preferably exposed at the surface of the base layer 200. Further, in order to improve the adhesion between the base layer 200 and the adhesive layer 300, the surface of the base layer 200 is preferably subjected to a surface treatment such as a corona treatment or anchor coating treatment.

### <Adhesive layer>

The adhesive layer 300 performs the role of bonding and supporting the semiconductor wafer or the like in the dicing step. When this adhesive layer 300 is irradiated with light following the dicing step, the layer adopts a state that enables the cut pieces of the semiconductor wafer or the like to be detached easily. Prior to use of the dicing tape 100, the adhesive layer 300 is typically protected by a release film.

The adhesive layer 300 is formed on one surface of the base layer 200 (see FIG. 1). The resin solution that represents the material for the adhesive layer 300 is usually applied to the base layer 200 using a coating method such as die coating, curtain coating, gravure coating, comma coating, bar coating or lip coating. Although there are no particular limitations on the thickness of the adhesive layer 300 following drying, the dried thickness is preferably at least 5 µm and not more than 30 µm, and is more preferably at least 10 µm and not more than 20 µm When the thickness of the adhesive layer 300 following drying is at least 5 µm and not more than 30 µm, the adhesive layer 300 exhibits good adhesive strength, and also exhibits good releasability following irradiation with ultraviolet rays or an electron beam or the like.

The adhesive layer 300 is composed mainly of a base resin and a curing component that cures the adhesive layer 300. The adhesive layer 300 may also contain other optional components such as an antistatic agent and a tackifier. Each of these components is described below in detail.

### (1) Base Resin

As the base resin, conventional resins used as adhesive layer components such as acrylic resins, silicone resins and urethane resins can be used, but from the viewpoints of heat resistance and cost, the use of an acrylic resin is preferable.

### (2) Curing Component

The curing component cures, for example, upon irradiation with light. This curing causes the base resin to become incorporated within a crosslinked structure of the curing component, and as a result, the adhesive strength of the adhesive layer 300 decreases. Examples of compounds that can be used as this type of curing component include low molecular weight compounds having at least two polymerizable carbon-carbon double bonds within each molecule that can generate three dimensional crosslinking upon irradiation with an energy beam such as ultraviolet rays or an electron beam or the like. Although there are no particular limitations, specific examples of the curing component include trimethylolpropane triacrylate, tetramethylolmethane tetraacrylate, pentaerythritol triacrylate, pentaerythritol tetraacrylate, dipentaerythritol monohydroxy pentaacrylate, dipentaerythritol hexaacrylate, 1,4-butylene glycol diacrylate 1,6-hexanediol diacrylate, polyethylene glycol diacrylate, and aromatic or aliphatic urethane acrylates (oligomers) such as commercially available oligoester acrylates. Among these, urethane acrylates are preferable.

Further, although not a particular limitation, the curing component preferably contains a mixture of two or more curing components having different weight-average molecular weights. The reason for this preference is that by using this type of curing component, the degree of crosslinking of the resin caused by light irradiation can be controlled, enabling the pickup properties to be improved. For example, this type of curing component may be composed of a mixture of a first curing component, and a second curing component having a larger weight-average molecular weight than that of the first curing component.

Moreover, the curing component may contain a photopolymerization initiator or a crosslinking agent or the like. A photopolymerization initiator is added to facilitate initiation of the polymerization of the curing component. Examples of the photopolymerization initiator include 2,2-dimethoxy-1,2-diphenylethan-1-one, benzophenone, acetophenone, benzoin, benzoin methyl ether, benzoin ethyl ether, benzoin isopropyl ether, benzyl diphenyl sulfide, tetramethylthiuram monosulfide, azobisisobutyronitrile, dibenzil, diacetyl and β-chloroanthraquinone.

The curing component is preferably added in an amount of at least 20 parts by weight but not more than 200 parts by weight, and more preferably at least 50 parts by weight but not more than 150 parts by weight, per 100 parts by weight of the base resin. By regulating the amount of the curing component in this manner, favorable pickup properties can be achieved for the dicing tape 100.

Examples of the crosslinking agent include epoxy-based crosslinking agents, isocyanate-based crosslinking agents, methylol-based crosslinking agents, chelate-based crosslinking agents, aziridine-based crosslinking agents, melamine-based crosslinking agents and polyvalent metal chelate-based crosslinking agents. Of these, an isocyanate-based crosslinking agent is preferable.

There are no particular limitations on the isocyanate-based crosslinking agent, and examples include polyvalent isocyanates such as polyisocyanate compounds and polyisocyanate compound trimers, terminal isocyanate compound trimers obtained by reacting a polyisocyanate compound and a polyol compound, and blocked polyisocyanate compounds in which a terminal isocyanate urethane prepolymer is blocked with a phenol or an oxime or the like.

Specific examples of polyvalent isocyanates that can be used include 2,4-tolylene diisocyanate, 2,6-tolylene diisocyanate, 1,3-xylylene diisocyanate, 1,4-xylylene diisocyanate, diphenylmethane-4,4'-diisocyanate, diphenylmethane-2,4'-diisocyanate, 3-methyldiphenylmethane diisocyanate, hexamethylene diisocyanate, isophorone diisocyanate, dicyclohexylmethane-4,4'-diisocyanate, and dicyclohexylmethane-2,4'-diisocyanate. Among these, at least one polyvalent isocyanate selected from the group consisting of 2,4-tolylene diisocyanate, diphenylmethane-4,4'-diisocyanate and hexamethylene diisocyanate is preferable.

The crosslinking agent is preferably added in an amount of at least 5 parts by weight but not more than 50 parts by weight per 100 parts by weight of the base resin. By regulating the amount of the crosslinking agent in this manner, favorable pickup properties can be achieved for the dicing tape 100.

### (3) Antistatic Agent

There are no particular limitations on the antistatic agent, and examples include surfactants such as anionic surfactants, cationic surfactants, nonionic surfactants and amphoteric surfactants. Furthermore, powders of carbon black, silver, nickel, antimony-doped tin oxide and tin-doped indium oxide and the like can be used as antistatic agents that exhibit no temperature dependency. Among these antistatic agents, carbon black, silver, antimony-doped tin oxide and tin-doped indium oxide are preferable.

### (4) Tackifier

There are no particular limitations on the tackifier, and examples of materials that can be used include rosin resins, terpene resins, coumarone resins, phenol resins, styrene resins, aliphatic petroleum resins, aromatic petroleum resins, and aliphatic-aromatic copolymer petroleum resins. Among these, phenol resins, aliphatic petroleum resins, aromatic petroleum resins, and aliphatic-aromatic copolymer petroleum resins are preferable.

### <1% Decay Time for Dicing Tape>

For the dicing tape 100, the 1% decay time at an applied voltage of ±5,000 V is typically not more than 0.15 seconds, preferably not more than 0.10 seconds, and still more preferably 0.05 seconds or less. The 1% decay time describes the time taken for the voltage of the dicing tape 100 to decay from 5,000 V to 50 V, or the time taken for the voltage to decay from -5,000 V to -50 V.

### <Method of Use>

The method of using the dicing tape 100 can employ conventional methods. For example, the dicing tape 100 may be adhered and affixed to a semiconductor wafer, and the semiconductor device then cut into individual element pieces using a rotating circular blade. Following cutting, the dicing tape 100 is irradiated from the side of the base layer 200 with ultraviolet rays or an electron beam or the like. Following irradiation with the ultraviolet rays or electron beam or the like, a special-purpose jig is used to expand the dicing tape 100 radially to widen the gaps between the chips to a specified distance, and the semiconductor devices are then pushed upward using needles or the like. The raised semiconductor devices are picked up using suction or the like from a vacuum collet or air pincette, and are subsequently mounted or stored on a tray.

Besides the dicing tape described above, the adhesive tape for processing a semiconductor wafer or the like according to the present invention may also be used in electronics applications as a back grind tape or a protective tape for printed circuit boards, and also as a protective film for window glass, a decorative marking film, and a substrate for drugs for medical and hygiene purposes.

### <Effects of the Present Embodiment>

The polymer-type antistatic agent is kneaded into the resin and dispersed within the base layer 200. As a result, even if the base layer 200 makes contact with and scrapes against machinery or the like, the polymer-type antistatic agent is not easily separated from the base layer 200. Accordingly, this dicing tape 100 can inhibit electrical charging in a stable manner. Moreover, in this polymer-type antistatic agent, the molecular chain that generates the antistatic effect is longer than that of conventional antistatic agents that are not polymer based. As a result, the dicing tape 100 has good antistatic performance.

A dicing tape 100 in which the MFR value of the polymer-type antistatic agent is at least 10.0 g/10 min can suppress any deterioration in processability. Moreover, a dicing tape 100 in which the MFR value of the polymer-type antistatic agent is not more than 15.0 g/10 min can suppress any reduction in the adhesive strength of the adhesive layer 300.

For the dicing tape 100, the 1% decay time at an applied voltage of ±5,000 V is not more than 0.15 seconds. The 1% decay time describes the time taken for the voltage of the dicing tape 100 to decay from 5,000 V to 50 V, or the time taken for the voltage to decay from -5,000 V to -50 V. The dicing tape 100 tends to exhibit a shorter decay time than conventional dicing tapes. As a result, the dicing tape 100 is able to better inhibit electrical charging.

This polymer-type antistatic agent has a higher melting point than conventional polymer-type antistatic agents By using this polymer-type antistatic agent, the melt viscosity of the base layer 200 increases, making the extrusion processability of the base layer 200 more favorable. Moreover, the occurrence of bleeding or contamination by low molecular weight components is inhibited.

### EXAMPLES

Examples 1 and 2 according to the dicing tape 100 of the present invention, and Comparative Examples 1 to 5 are described below. However, the present invention is in no way limited by these examples.

### (Example 1)

### <Preparation of Dicing Tape>

A material for forming the base layer 200 was prepared by combining 60 parts by weight of a polypropylene, 40 parts by weight of a block copolymer formed from a polystyrene segment represented by general formula (1) and a vinyl polyisoprene segment represented by general formula (2), and 15 parts by weight of a polyether/polyolefin block polymer (product name: Pelestat 230, manufactured by Sanyo Chemical Industries, Ltd.) as a polymer-type antistatic agent having an MFR of 12 g/10 min. The MFR measurement was performed under conditions of 190°C and 21.18 N in accordance with JIS K7210. 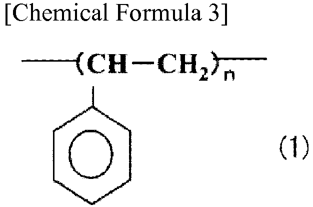 In formula (1), n represents an integer of 2 or greater. 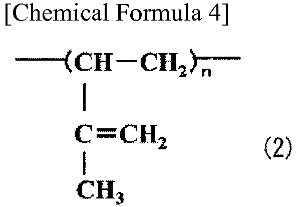 In formula (2), n represents an integer of 2 or greater.

The above material for forming the base layer 200 was kneaded in a biaxial kneader, and the kneaded product was then extruded through an extruder to prepare a base layer 200 having a thickness of 100 µm.

A base resin for the adhesive layer 300 was prepared by combining 10 parts by weight of a first copolymer and 90 parts by weight of a second copolymer. As the first copolymer, a copolymer having a weight-average molecular weight of 500,000 obtained by copolymerizing 70 parts by weight of butyl acrylate, 25 parts by weight of 2-ethylhexyl acrylate and 5 parts by weight of vinyl acetate was used. As the second copolymer, a copolymer having a weight-average molecular weight of 300,000 obtained by copolymerizing 50 parts by weight of 2-ethylhexyl acrylate, 10 parts by weight of butyl acrylate, 37 parts by weight of vinyl acetate and 3 parts by weight of 2-hydroxyethyl methacrylate was used.

As a curing component for the adhesive layer 300, 30 parts by weight of each of a difunctional urethane acrylate having a weight-average molecular weight of 11,000 and a pentafunctional acrylate monomer having a weight-average molecular weight of 500 were prepared per 100 parts by weight of the base resin. As a photopolymerization initiator for the adhesive layer 300, 5 parts by weight of 2,2-dimethoxy-2-phenylacetophenone was prepared per 100 parts by weight of the base resin. As a crosslinking agent for the adhesive layer 300, 6 parts by weight of a polyisocyanate-based crosslinking agent was prepared per 100 parts by weight of the base resin.

A resin solution was prepared by blending the aforementioned base resin, curing component, photopolymerization initiator and crosslinking agent for the adhesive layer 300. This resin solution was applied to the base layer 200 by bar coating so as to form a thickness following drying of 10 µm for the adhesive layer 300, and the solution was then dried at 80°C for 5 minutes to obtain the desired dicing tape 100.

### <Evaluation of Separability of Antistatic Agent>

For the obtained dicing tape 100, the separability of the antistatic agent was evaluated by the cross-cut method, in accordance with JIS K 5600-5-6. In this cross-cut method, a grid of cuts was formed in the dicing tape 100 at 1 mm intervals, a prescribed tape was subsequently stuck to the dicing tape 100 and then peeled away from the dicing tape 100, and the results of the test were classified. Based on the standard, a "classification 0" was awarded when none of the grid squares was peeled off, and "classifications 1 to 5" were awarded when some peeling occurred. When the result of the cross-cut test was "evaluation 0", the separability was recorded using the symbol ○, whereas the symbol × was recorded in all other cases.

The result of performing the above evaluation yielded a result of "classification 0" for the cross-cut test performed on the dicing tape 100. As a result, the evaluation of the separability of the antistatic agent in the dicing tape 100 was recorded as ○ (see Table 1 below).

### <Measurement of Surface Resistance and Volume Resistance>

For the base layer 200 prior to provision of the adhesive layer 300, a static electricity decay time measurement apparatus (product name: Static Decay Meter Model 406C, manufactured by Electro-Tech System, Inc.) was used to measure the surface resistance and the volume resistance. For the surface resistance measurement, the surface resistance was measured for both the surface of the base layer 200 on which the adhesive layer 300 is provided, and the surface opposite this surface.

The results of performing these measurements revealed that the surface resistance of both surfaces of the base layer 200 was 1.0E+10 Ω/square, and the volume resistance was 1.0E+12 Ωm (see Table 1 below).

### <Measurement of 1% Decay Time>

For the obtained dicing tape 100, the 1% decay time was measured in accordance with MIL-B-81705C. Specifically, a static electricity decay time measurement apparatus (product name: Static Decay Meter Model 406C, manufactured by Electro-Tech System, Inc.) was used to apply a voltage of 5,000 V to the dicing tape 100, and the time taken for the voltage of the dicing tape 100 to decay from 5,000 V to 50 V was measured. This measurement was performed on both the surface of the dicing tape 100 on the side of the base layer 200, and the surface on the side of the adhesive layer 300.

The results of performing the above measurements revealed that the 1% decay time for the surface on the side of the base layer 200 was 0.04 seconds, and the 1% decay time for the surface on the side of the adhesive layer 300 was 0.04 seconds (see Table 1 below).

### <Evaluation of Adhesive Strength Ratio>

A dicing tape 100 for which at least 7 days had elapsed since preparation was bonded to a semiconductor wafer. The adhesive strength of the bond between the dicing tape 100 and the semiconductor wafer after standing for 20 minutes at normal temperature following bonding of the semiconductor wafer (hereafter referred to as the "first adhesive strength") was measured using a 180° peel test. Moreover, a dicing tape 100 that had been stored at 40°C for one week was also bonded to a semiconductor wafer, and the adhesive strength of the bond between this dicing tape 100 and the semiconductor wafer after standing for 20 minutes at normal temperature following bonding of the semiconductor wafer (hereafter referred to as the "second adhesive strength") was also measured using a 180° peel test.

The 180° peel test was performed using a universal tester (product name: Tensilon, manufactured by A&D Company, Ltd.) under conditions including an ambient temperature of 23°C, an ambient pressure at normal pressure, and a pull speed of 300 mm/min. The average value of the thus obtained adhesive strength chart was recorded as the adhesive strength (cN/25 mm) of the adhesive layer 300. Dicing tapes for which the ratio between the measured first adhesive strength and second adhesive strength (first adhesive strength / second adhesive strength) was at least 0.5 but not more than 2.0 were evaluated as ○, and all other dicing tapes were evaluated as ×. In the case of a dicing tape 100 for which the adhesive strength ratio evaluation is ○, low molecular weight components are unlikely to bleed from the base layer 200, and the adhesive strength of the adhesive layer 300 is resistant to deterioration, even after storage at a high temperature of 40°C.

The results of performing the above evaluations revealed a first adhesive strength of 160 cN/25 mm and a second adhesive strength of 120 cN/25 mm. Accordingly, the evaluation of the adhesive strength ratio for the dicing tape 100 was recorded as ○ (see Table 1 below).

### <Evaluation of Charge Potential of Semiconductor Wafer>

A semiconductor wafer from which static charge had been removed was bonded to a dicing tape 100 from which static charge had been removed, and the charge potential of the semiconductor wafer was then measured from a distance of 10 mm from the surface of the wafer using a surface potential meter (product name: S1HS, manufactured by SUNX Sensors). The absolute value of the measured surface potential was evaluated as ○ if less than 50 V, evaluated as Δ if at least 50 V but less than 100 V, and evaluated as × if 100 V or greater.

The result of performing the above evaluation revealed a charge potential for the semiconductor wafer of -6 V. Accordingly, the evaluation of the charge potential of the semiconductor wafer was recorded as ○ (see Table 1 below).

### <Evaluation of Film Processability>

For the dicing tape 100, if the external appearance was visually uniform and the common difference in the thickness within a 1 m × 1 m region was less than 5 µm then the film processability was evaluated as ○, if the external appearance was visually uniform but the common difference in the thickness within a 1 m × 1 m region was 5 µm or greater then the film processability was evaluated as Δ, and if the external appearance lacked visual uniformity then the film processability was evaluated as ×.

The result of performing the above evaluation revealed that the external appearance of the dicing tape 100 was visually uniform, and the common difference in the thickness within a 1 m × 1 m region was 3 µm. Accordingly, the evaluation of the film processability was recorded as ○ (see Table 1 below).

### (Example 2)

With the exception of the change described below, a dicing tape 100 was obtained in the same manner as that described for Example 1. As one of the materials for forming the base layer 200, a polyether/polyolefin block polymer (product name: Pelestat 212, manufactured by Sanyo Chemical Industries, Ltd.) was prepared as a polymer-type antistatic agent having an MFR of 12 g/10 min.

Using the same methods as those described for Example 1, this dicing tape 100 was subjected to evaluation of the separability of the antistatic agent, measurement of the surface resistance and the volume resistance, measurement of the 1% decay time, evaluation of the adhesive strength ratio, evaluation of the charge potential of the semiconductor wafer, and evaluation of the film processability.

The results included a result for the cross-cut test on the dicing tape 100 according to the present example of "classification 0", meaning the evaluation of the separability of the antistatic agent was recorded as ○. The surface resistance value for both surfaces of the base layer 200 was 1.0E+11 Ω/square, and the volume resistance was 1.0E+13 Ωm. The 1% decay time for the surface on the side of the base layer 200 was 0.02 seconds, and the 1% decay time for the surface on the side of the adhesive layer 300 was 0.02 seconds. The first adhesive strength value was 150 cN/25 mm, and the second adhesive strength value was 110 cN/25 mm, and therefore the evaluation of the adhesive strength ratio for the dicing tape 100 was recorded as ○. The charge potential of the semiconductor wafer was -4 V, meaning the evaluation of the charge potential of the semiconductor wafer was ○. The external appearance of the dicing tape 100 was visually uniform, and the common difference in the thickness within a 1 m × 1 m region was 3 µm, and therefore the evaluation of the film processability was recorded as ○ (see Table 1 below).

### (Comparative Example 1)

With the exception of the changes described below, a dicing tape was obtained in the same manner as that described for Example 1. As one of the materials for forming the base layer 200, an antistatic agent (product name: Electrostripper AC, manufactured by Kao Corporation) was prepared. This antistatic agent was not kneaded into the base layer 200, but was rather applied to the surface of the base layer 200 opposite the surface on which the adhesive layer 300 is provided.

Using the same methods as those described for Example 1, this dicing tape was subjected to evaluation of the separability of the antistatic agent, measurement of the surface resistance and the volume resistance, measurement of the 1% decay time, evaluation of the adhesive strength ratio, evaluation of the charge potential of the semiconductor wafer, and evaluation of the film processability. The measurements of the surface resistance and the volume resistance were performed in a state where the antistatic agent had been applied to the base layer 200.

The results included a result for the cross-cut test on the dicing tape according to the present comparative example of "classification 5", meaning the evaluation of the separability of the antistatic agent was recorded as ×. The surface resistance of the surface of the base layer 200 on which the adhesive layer 300 is provided was 1.0E+14 Ω/square, the surface resistance of the opposite surface was 1.0E+10 Ω/square, and the volume resistance was 1.0E+15 Ωm. The 1% decay time for the surface on the side of the base layer 200 was 0.06 seconds, whereas no decay occurred on the surface on the side of the adhesive layer 300. The first adhesive strength value was 165 cN/25 mm, and the second adhesive strength value was 145 cN/25 mm, and therefore the evaluation of the adhesive strength ratio for the dicing tape 100 was recorded as ○. The charge potential of the semiconductor wafer was -78 V, meaning the evaluation of the charge potential of the semiconductor wafer was Δ. The external appearance of the dicing tape 100 lacked uniformity, and the common difference in the thickness within a 1 m × 1 m region was 2 µm, and therefore the evaluation of the film processability was recorded as ○ (see Table 1 below).

### (Comparative Example 2)

With the exception of the changes described below, a dicing tape was obtained in the same manner as that described for Example 1. As one of the materials for forming the base layer 200, an antistatic agent (product name: Electrostripper AC, manufactured by Kao Corporation) was prepared. This antistatic agent was not kneaded into the base layer 200, but was rather applied to both surfaces of the base layer 200.

Using the same methods as those described for Example 1, this dicing tape was subjected to evaluation of the separability of the antistatic agent, measurement of the surface resistance and the volume resistance, measurement of the 1% decay time, evaluation of the adhesive strength ratio, evaluation of the charge potential of the semiconductor wafer, and evaluation of the film processability. The measurements of the surface resistance and the volume resistance were performed in a state where the antistatic agent had been applied to the base layer 200.

The results included a result for the cross-cut test on the dicing tape according to the present comparative example of "classification 5", meaning the evaluation of the separability of the antistatic agent was recorded as ×. The surface resistance value for both surfaces of the base layer 200 was 1.0E+10 Ω/square, and the volume resistance was 1.0E+15 Ωm. The 1% decay time for the surface on the side of the base layer 200 was 0.06 seconds, and the 1% decay time for the surface on the side of the adhesive layer 300 was 0.06 seconds. The first adhesive strength value was 155 cN/25 mm, and the second adhesive strength value was 60 cN/25 mm, and therefore the evaluation of the adhesive strength ratio for the dicing tape 100 was recorded as ×. The charge potential of the semiconductor wafer was -53 V, meaning the evaluation of the charge potential of the semiconductor wafer was Δ. The external appearance of the dicing tape 100 lacked uniformity, and the common difference in the thickness within a 1 m × 1 m region was 2 µm, and therefore the evaluation of the film processability was recorded as ○ (see Table 1 below).

### (Comparative Example 3)

With the exception of the change described below, a dicing tape was obtained in the same manner as that described for Example 1. An antistatic agent was not used as one of the materials for forming the base layer 200. In other words, the dicing tape was not subjected to any antistatic treatment.

Using the same methods as those described for Example 1, this dicing tape was subjected to measurement of the surface resistance and the volume resistance, measurement of the 1% decay time, evaluation of the adhesive strength ratio, evaluation of the charge potential of the semiconductor wafer, and evaluation of the film processability. In Comparative Example 3, because the dicing tape had not been subjected to any antistatic treatment, an evaluation of the separability of the antistatic agent was not performed.

The results included a surface resistance value for both surfaces of the base layer 200 of 1.0E+14 Ω/square, and a volume resistance value of 1.0E+16 Ωm. No decay occurred on either the surface on the side of the base layer 200, or the surface on the side of the adhesive layer 300. The first adhesive strength value was 170 cN/25 mm, and the second adhesive strength value was 165 cN/25 mm, and therefore the evaluation of the adhesive strength ratio for the dicing tape 100 was recorded as ○. The charge potential of the semiconductor wafer was -245 V, meaning the evaluation of the charge potential of the semiconductor wafer was × The external appearance of the dicing tape 100 was visually uniform, and the common difference in the thickness within a 1 m × 1 m region was 2 µm, and therefore the evaluation of the film processability was recorded as ○ (see Table 1 below).

### (Comparative Example 4)

With the exception of the change described below, a dicing tape was obtained in the same manner as that described for Example 1. As one of the materials for forming the base layer 200, an antistatic agent having an MFR of 30 g/10 min was prepared (product name: Pelestat 300, manufactured by Sanyo Chemical Industries, Ltd.).

Using the same methods as those described for Example 1, this dicing tape was subjected to evaluation of the separability of the antistatic agent, measurement of the surface resistance and the volume resistance, measurement of the 1% decay time, evaluation of the adhesive strength ratio, evaluation of the charge potential of the semiconductor wafer, and evaluation of the film processability.

The results included a result for the cross-cut test on the dicing tape according to the present comparative example of "classification 0", meaning the evaluation of the separability of the antistatic agent was recorded as ○. The surface resistance value for both surfaces of the base layer 200 was 1.0E+10 Ω/square, and the volume resistance was 1.0E+12 Ωm. The 1% decay time for the surface on the side of the base layer 200 was 0.04 seconds, and the 1% decay time for the surface on the side of the adhesive layer 300 was 0.04 seconds. The first adhesive strength value was 140 cN/25 mm, and the second adhesive strength value was 55 cN/25 mm, and therefore the evaluation of the adhesive strength ratio for the dicing tape 100 was recorded as ×. The charge potential of the semiconductor wafer was -23 V, meaning the evaluation of the charge potential of the semiconductor wafer was ○. The external appearance of the dicing tape 100 was visually uniform, and the common difference in the thickness within a 1 m × 1 m region was 3 µm, and therefore the evaluation of the film processability was recorded as ○ (see Table 1 below).

### (Comparative Example 5)

With the exception of the change described below, a dicing tape was obtained in the same manner as that described for Example 1. As one of the materials for forming the base layer 200, an antistatic agent having an MFR of 7 g/10 min was prepared (product name: Pelestat VH2, manufactured by Sanyo Chemical Industries, Ltd.).

Using the same methods as those described for Example 1, this dicing tape was subjected to evaluation of the separability of the antistatic agent, measurement of the surface resistance and the volume resistance, measurement of the 1% decay time, evaluation of the adhesive strength ratio, evaluation of the charge potential of the semiconductor wafer, and evaluation of the film processability.

The results included a result for the cross-cut test on the dicing tape according to the present comparative example of "classification 0", meaning the evaluation of the separability of the antistatic agent was recorded as ○. The surface resistance value for both surfaces of the base layer 200 was 1.0E+10 Ω/square, and the volume resistance was 1.0E+12 Ωm. The 1% decay time for the surface on the side of the base layer 200 was 0.04 seconds, and the 1% decay time for the surface on the side of the adhesive layer 300 was 0.04 seconds. The first adhesive strength value was 165 cN/25 mm, and the second adhesive strength value was 130 cN/25 mm, and therefore the evaluation of the adhesive strength ratio for the dicing tape 100 was recorded as ○. The charge potential of the semiconductor wafer was -18 V, meaning the evaluation of the charge potential of the semiconductor wafer was ○. The external appearance of the dicing tape 100 lacked uniformity, and the common difference in the thickness within a 1 m × 1 m region was 7 µm, and therefore the evaluation of the film processability was recorded as Δ (see Table 1 below).

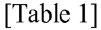

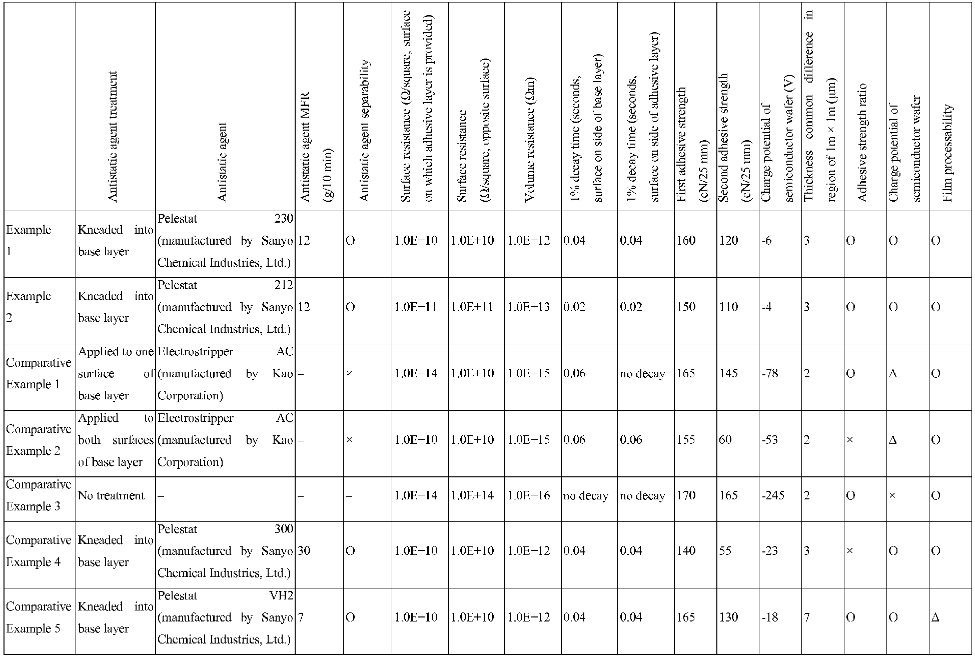

In the dicing tapes 100 according to Examples 1 and 2, the 1% decay time for the surface on the side of the base layer 200 and the 1% decay time for the surface on the side of the adhesive layer 300 were both not more than 0.04 seconds, and the evaluation of the separability of the antistatic agent, the evaluation of the adhesive strength ratio, the evaluation of the charge potential of the semiconductor wafer and the evaluation of the film processability were all ○. In contrast, in the dicing tapes according to Comparative Examples 1 to 3, the 1% decay time for the surface on the side of the base layer 200 and the 1% decay time for the surface on the side of the adhesive layer 300 both exceeded 0.04 seconds. Further, in the dicing tapes according to Comparative Examples 1 to 5, at least one of the evaluation of the separability of the antistatic agent, the evaluation of the adhesive strength ratio, the evaluation of the charge potential of the semiconductor wafer and the evaluation of the film processability was either Δ or ×.

### INDUSTRIAL APPLICABILITY

The adhesive tape for processing a semiconductor wafer or the like according to the present invention is capable of inhibiting electrical charging in a stable manner.

### DESCRIPTION OF THE REFERENCE SIGNS

- 100:: Adhesive tape for processing a semiconductor wafer or the like (Dicing tape)
- 200:: Base layer
- 300:: Adhesive layer

## Claims

1. An adhesive tape for processing a semiconductor wafer or the like, the adhesive tape comprising:
a base layer, and
an adhesive layer formed on the base layer, wherein
the adhesive layer comprises a curing component that cures the adhesive layer,
the base layer is composed mainly of a resin into which a polymer-type antistatic agent has been kneaded, and
the polymer-type antistatic agent has a melt mass flow rate (MFR), measured under measurement conditions of 190°C and 21.18 N in accordance with JIS K7210, of at least 10.0 g/10 min and not more than 15.0 g/10 min.

2. An adhesive tape for processing a semiconductor wafer or the like, the adhesive tape comprising:
a base layer, and
an adhesive layer formed on the base layer, wherein
the adhesive layer comprises a curing component that cures the adhesive layer,
the base layer is composed mainly of a resin in which a polymer-type antistatic agent has been dispersed, and
the polymer-type antistatic agent has a melt mass flow rate (MFR), measured under measurement conditions of 190°C and 21.18 N in accordance with JIS K7210, of at least 10.0 g/10 min and not more than 15.0 g/10 min.

3. The adhesive tape for processing a semiconductor wafer or the like according to claim 1 or 2, wherein a 1% decay time at an applied voltage of ±5,000 V is not more than 0.15 seconds.

4. The adhesive tape for processing a semiconductor wafer or the like according to claim 1 or 2, wherein a melting point of the polymer-type antistatic agent is at least 140°C.

5. The adhesive tape for processing a semiconductor wafer or the like according to claim 1 or 2, wherein the resin is a mixture of a polypropylene and an elastomer.

6. The adhesive tape for processing a semiconductor wafer or the like according to claim 1 or 2, wherein the resin is a mixture of a polyethylene and an elastomer.

7. The adhesive tape for processing a semiconductor wafer or the like according to claim 1 or 2, wherein the polymer-type antistatic agent contains not more than 100 ppm of cations and not more than 100 ppm of anions based on a weight of the polymer-type antistatic agent.
